# EUROPEAN PATENT APPLICATION

(11) **EP 2 636 773 A1**
(43) Date of publication of application: **11.09.2013**
(21) Application number: 11838032.8
(22) Date of filing: 01.11.2011
(51) Int. Cl.: C30B 29/12, C09K 11/00, C09K 11/64, H01J 47/12, G01T 3/06

(54) **METAL FLUORIDE CRYSTAL, AND LIGHT-EMITTING ELEMENT**

(30) Priority: 02.11.2010 JP 2010246711
(71) Applicant: Tokuyama Corporation, Shunan-shi, Yamaguchi-ken 745-8648 (JP); Tohoku University, Aoba-ku Sendai-shi Miyagi 980-8577 (JP)
(72) Inventor: ISHIZU, Sumito, Shunan-shi Yamaguchi 745-8648 (JP); FUKUDA, Kentaro, Shunan-shi Yamaguchi 745-8648 (JP); KAWAGUCHI, Noriaki, Shunan-shi Yamaguchi 745-8648 (JP); YOSHIKAWA, Akira, Sendai-shi Miyagi 980-8577 (JP); YANAGIDA, Takayuki, Sendai-shi Miyagi 980-8577 (JP); YOKOTA, Yui, Sendai-shi Miyagi 980-8577 (JP); FUJIMOTO, Yutaka, Sendai-shi Miyagi 980-8577 (JP)
(74) Representative: Jackson, Martin Peter
(86) International application number: PCT/JP2011/075197
(87) International publication number: WO 2012/060382

(57) **Abstract**

[Problems to be Solved] To provide a neutron scintillator which shows a large amount of luminescence in response to neutrons and which is excellent in neutron detection efficiency and n/γ discrimination ability; and a metal fluoride crystal suitable for the neutron scintillator.

[Means to Solve the Problems] A metal fluoride crystal, as a parent crystal, represented by the chemical formula LiM¹M²F₆ (where M¹ represents at least one alkaline earth metal element selected from the group consisting of Mg, Ca, Sr and Ba, and M² represents at least one metal element selected from the group consisting of Al, Ga and Sc), such as lithium calcium aluminum fluoride, lithium strontium aluminum fluoride, or lithium magnesium aluminum fluoride, the metal fluoride crystal containing at least one alkali metal element selected from the group consisting of Na, K, Rb and Cs, and also containing Eu; and a light-emitting device comprising the crystal, such as a neutron scintillator.

## Description

### Technical Field:

This invention relates to a novel metal fluoride crystal and a light-emitting device comprising the crystal. More specifically, the invention relates to a metal fluoride crystal useful as a neutron scintillator, the metal fluoride crystal containing an alkali metal element and europium.

### Background Art:

Metal fluoride crystals are crystals of metal compounds which are expected to find wide varieties of uses. For example, single crystals of calcium fluoride, magnesium fluoride, etc. have high perviousness, low refractive index, and low dispersion over a broad range of wavelength bandwidths, ranging from the vacuum ultraviolet region to the infrared region, and also have excellent chemical stability. Thus, they are used as optical materials in a wide range of fields, including window materials, lenses and prisms. In particular, they are highly expected to be used as window materials, light source system lenses, illumination system lenses, and projection system lenses in apparatuses such as steppers (reduction projection aligners) using an ArF laser (193 nm) or F2 laser (157 nm) light source under development as a next-generation short wavelength light source in photolithography technologies.
A lithium calcium aluminum fluoride (may hereinafter be referred to as LiCAF) single crystal is a crystal widely used as a laser oscillation device, and a laser oscillation device having a dopant, such as a cerium (Ce) element, added thereto is known (Patent Document 1). Moreover, a metal fluoride crystal represented by the chemical formula La_{1-x-y}BaₓNd_{y}F₃₋ₓ is known as a light-emitting device which emits vacuum ultraviolet light at 175 nm, and an erbium (Er) -doped LiCAF single crystal is known as a vacuum ultraviolet light-emitting device at 163 nm (Patent Documents 2 and 3).

For metal fluoride crystals, on the other hand, their development as neutronscintillatorsfor usein neutron detectors is underway. The neutron scintillator refers to a substance which, when hit by neutrons, absorbs the neutrons to emit fluorescence. The various performance characteristics of the neutron detector using the scintillator, for example, a detection efficiency for neutrons, the count rate of neutrons, and the ability to discriminate between neutrons and γ rays (may herein after be referred to as n/γ discriminationability), depend on the substance constituting the scintillator. For instance, the magnitude of luminescence intensity of the scintillator or variations in its luminescence intensity affect discrimination from background noise. Since the background noise is mainly ascribed to γ rays, n/γ discrimination ability is eventually influenced. That is, if the discrimination ability for neutrons versus γ rays is low, a signal which does not reflect the interaction between neutrons and an object to be inspected enters, and background noise due to γ rays increases. Moreover, the rapidity of attenuation of fluorescence affects the count rate. The detection efficiency means the ratio of the number of radiations counted by the detector to the number of radiations emitted from a radiation source and entered into the detector. The count rate means the number of radiations counted per unit time.

LiF/ZnS has been used as a neutron scintillator having a relatively high neutron detection efficiency and excellent n/γ discrimination ability (Non-Patent Document 1). Since the LiF/ZnS is opaque, however, an increase in the thickness of the scintillator has made it impossible to take out scintillation light efficiently. Thus, the LiF/ZnS has been limited in the improvement of the neutron detection efficiency. A proposal has been made for a neutron scintillator using a eutectic composed of europium-containing calcium fluoride crystals and lithium fluoride crystals (Non-Patent Document 2). This neutron scintillator composed of the eutectic is translucent, and enables scintillation light to be withdrawn with high efficiency. Thus, this neutron scintillator can achieve a very high neutron detection efficiency. According to studies by the inventors of the present invention, however, the eutectic has been poor in n/γ discrimination ability, has provided a small amount of luminescence, and still has left room for improvement.

### Prior Art Documents:

### Patent Documents:

Patent Document 1: JP-A-2009-94268
Patent Document 2: JP-A-2008-201599
Patent Document 3: JP-A-2010-73936

### Non-Patent Documents:

Non-Patent Document 1: N.J. Rhodes, et al., "Pixelated neutron scintillation detectors using fibre optic coded arrays" , Nuclear Instruments and Methods in Physics Research, A392, 315-318 (1997).
Non-Patent Document 2: J. Trojan-Piegza, et al., "CaF2(Eu2+):LiF- Structural and spectroscopic properties of a new system for neutron detection", Radiation Measurements, 45, 163-167 (2010).

### Summary of the Invention:

### Problems to be solved by the invention:

It is an object of the present invention to provide a neutron scintillator showing a large amount of luminescence and excellent in neutron detection efficiency and n/γ discrimination ability, and a crystal substance preferred for the neutron scintillator.

### Means for solving the problems:

The present inventors have conducted various studies on the type of adopant tobe incorporated in a metal fluoride crystal, the conditions for incorporating the dopant, and so on. As a result, they have found that luminescence intensity can be enhanced dramatically by selecting europium (Eu) as a dopant, andhavinga specific alkali metal element coexist in the crystal. This finding has led them to accomplish the present invention.

That is, according to the present invention, there is provided a metal fluoride crystal represented by the chemical formula LiM¹M²F₆ where M¹ represents at least one alkaline earth metal element selected from the group consisting of Mg, Ca, Sr and Ba, and M² represents at least one metal element selected from the group consisting of Al, Ga and Sc, wherein the crystal contains at least one alkali metal element selected from the group consisting of Na, K, Rb and Cs, and also contains Eu.
In the metal fluoride crystal, it is preferred that
1) the content of the alkali metal element be 0.001 to 10 mol% based on the metal fluoride crystal, and the content of the Eu be 0.001 to 5 mol% based on the metal fluoride crystal;
2) the alkali metal element be Na;
3) the metal fluoride crystal be lithium calcium aluminum fluoride (LiCaAlF₆); and
4) the isotopic ratio of ⁶Li be 50% or higher.
According to the present invention, there is further provided a light-emitting device comprising the metal fluoride crystal, preferably, a neutron scintillator.

### Effects of the invention:

The present invention can provide a neutron scintillator having a large amount of luminescence, a high detection efficiency for neutrons, and excellent n/γ discrimination ability. Because of these features of showing a large amount of luminescence and a high detection efficiency, the neutron scintillator can measure neutrons even in a small amount. Furthermore, the neutron scintillator is excellent in n/γ discrimination ability. Consequently, the neutron scintillator suppresses the influence of γ rays, which may be emitted together with neutron, and enables measurements to be made at a high S/N ratio.
A neutron detector using such a neutron scintillator can be preferably used in scientific research fields such as structural analyses by neutron diffraction, nondestructive inspection fields, or security fields such as cargo inspection.

### Brief Description of the Drawings:

[Fig. 1] is a schematic view of crystal growth by the micro-pulling-down method.
[Fig. 2] is a schematic view of a neutron detector.
[Fig. 3] is a view showing the results of comparison between the amounts of luminescence by Eu-doped LiCAF and Na- and Eu-doped LiCAF when irradiated with neutrons.
[Fig. 4] is a view showing the n/γ discrimination ability of the Na-Eu-doped LiCAF of Example 1 when irradiated with neutron and irradiated with γ rays.
[Fig. 5] is a view showing the n/γ discrimination ability of the Eu-doped LiCAF when irradiated with neutron and irradiated with γ rays.
[Fig. 6] is a view showing the n/γ discrimination ability of Na-Eu-doped LiCAF of Example 2 when irradiated with neutron and irradiated with γ rays.
[Fig. 7] is a view showing the n/γ discrimination ability of Na-Eu-doped LiCAF of Example 3 when irradiated with neutron and irradiated with γ rays.

### Mode for Carrying Out the Invention:

The metal fluoride crystal of the present invention involves, as a basic configuration (parent crystal), a crystal of a metal fluoride containing a lithium element, an alkaline earth metal element, and a metal element, and has europium (Eu) as a dopant, and a specific alkali metal element, incorporated into such a crystal substance.
The metal fluoride crystal can be used preferably as a neutron scintillator, because it emits scintillation light based on the following course upon entry of neutrons.
First, when neutrons are incident on the metal fluoride crystal, the neutrons are captured by ⁶Li-isotope in the metal fluoride crystal, whereby a capture reaction takes place to generate secondary particles, i.e., α particles and tritium. Then, such secondary particles migrate in the crystal, exciting the europium. Finally, the excited europium emits scintillation light. That is, the metal fluoride crystal and europium of the metal fluoride crystal of the present invention act, respectively, as a neutron capturing material and a fluorescent substance emitting scintillation light.

The metal fluoride crystal of the present invention has a parent crystal which is a crystal of a metal fluoride represented by the chemical formula LiM¹M²F₆ (where M¹ represents at least one alkaline earth metal element selected from the group consisting of Mg, Ca, Sr and Ba, and M² represents at least one metal element selected from the group consisting of Al, Ga and Sc), and which is a colorless, transparent crystal and belongs to the hexagonal system. This crystal has satisfactory chemical stability and, when it is used in an ordinary manner, its performance does not deteriorate over a short term. Furthermore, its mechanical strength and processability are satisfactory, and it can be processed into a desired shape and used.
In the above chemical formula, M¹ represents an alkaline earth metal element such as magnesium (Mg), calcium (Ca), strontium (Sr) or barium (Ba) , and M² represents a metal element such as aluminum (Al), gallium (Ga) or scandium (Sc).
Concrete examples of the parent crystal are lithium calcium aluminum fluoride (LiCaAlF₆), lithium strontium aluminum fluoride (LiSrAlF₆), lithium magnesium aluminum fluoride (LiMgAlF₆), and lithium calcium gallium fluoride (LiCaGaF₆). Of them, lithium calcium aluminum fluoride (LiCaAlF₆) is preferred in that its average atomic weight is low, its sensitivity to gamma rays is low, its ionic radius is similar to that of Eu, and it has an easily substitutable site.
In the metal fluoride crystal, it is preferred that the ⁶Li-isotope ratio in the Li element included in the crystal be 50% or more. By setting the ⁶Li-isotope ratio at 50% or more, the probability for the aforementioned capture reaction increases to raise the detection efficiency for neutrons. By setting the ⁶Li-isotope ratio at 90% or more, the probability for the capture reaction further increases to raise the detection efficiency for neutrons further.

The metal fluoride parent crystal of the present invention is characterized by containing the Eu element and at least one alkali metal element selected from among sodium (Na), potassium (K), rubidium (Rb) and cesium (Cs). The coexistence of both these elements in the parent crystal enhances the luminescence intensity, but amechanismbehindthis advantage remains unknown.

In the metal fluoride crystal of the present invention, the higher the content of Eu for the LiM¹M²F₆ parent crystal, the higher brightness the resulting luminescence can show. If this content is too high, however, the transparency of the crystal in the ultraviolet region lowers, and the crystal itself absorbs ultraviolet light emitted, with the result that the amount of luminescence decreases. Thus, the content of Eu for the LiM¹M²F₆ parent crystal is preferably 0.001 to 5 mol% based on the LiM¹M²F_{6.} By setting the content at 0.001 mol% or more, luminescence of high brightness can be obtained. By setting the content at 5 mol% or less, a Eu-doped LiM¹M²F₆ crystal with high transparency in the ultraviolet region can be obtained. The content of Eu is further preferably 0.01 to 0.5 mol% based on the LiM¹M²F₆. By rendering the content 0.01 mol% or more, luminescence of even higher brightness can be obtained. By setting the content at 0.5 mol% or less, a crystal of high perviousness can be obtained in a high yield. The doped Eu is assumed to be present in the lattice spacing of the parent crystal or be present as substituting the alkaline earth element, but its exact existential state is not clear.

The content of the at least one alkali metal element selected from among Na, K, Rb and Cs is preferably 0.001 to 10 mol% based on the LiM¹M²F₆. By setting the content at 0.001 mol% or more, the content of Eu contained in the crystal can be increased. By setting the content at 10 mol% or less, a decrease in the transmittance of the crystal due to the precipitation of the excess alkali metal element can be suppressed. Further preferably, the content of the alkali metal element is 0.01 to 5 mol%. In the crystal, the alkali metal element is assumed to be present interstitially in the LiM¹M²F₆ parent crystal, but its exact existential state is not clear.
The contents of the Eu and the alkali metal element can be adjusted by the amount of a Eu material as a Eu source, and the amount of an alkali metal material as an alkali metal element source, which are added to a material mixture for the production of the crystal.

A method of producing the metal fluoride crystal of the present invention is not limited, and includes, for example, the Bridgman method in which a crucible is lowered to solidify a melt in one direction from below to above; the Czochralski method in which with a solid-liquid interface being held at a constant position, a crystal is pulled up while being solidified in one direction; and the micro-pulling-down method in which with a solid-liquid interface being held at a constant position, a crystal is pulled down while being solidified in one direction.

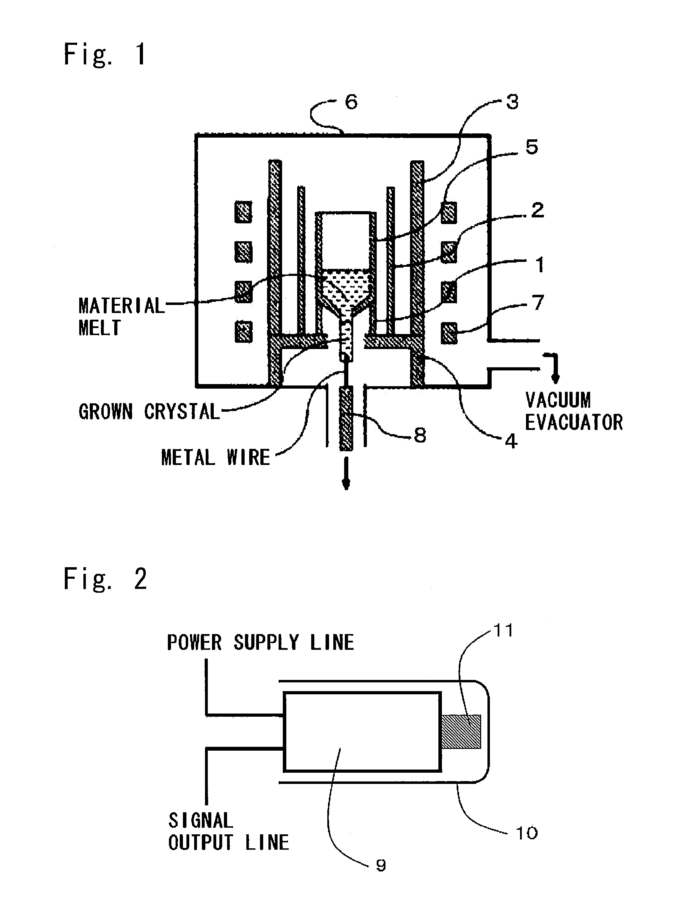

The production method will be described in detail below, with the micro-pulling-down method taken as an example. The micro-pulling-down method is a method in which a melt of raw materials is withdrawn through a hole provided at the bottom of a crucible 5 with the use of an apparatus as shown in Fig. 1, whereby a crystal is produced.
First, predetermined amounts of materials are charged into the crucible 5 provided with a hole at its bottom. The shape of the hole provided in the bottom of the crucible is not limited, but is preferably a cylindrical shape having a diameter of 0.5 to 4 mm and a length of 0 to 2 mm.
The materials used in the present invention (to be described later) preferably have purity of 99.99% or higher each. By using such materials, the purity of the resulting crystal can be increased, and an increase in the amount of luminescence is expected. As the materials, a material mixture of these materials mixed beforehand may be charged into the crucible. Alternatively, the materials may be used after being mixed and once sintered or melt-solidified.

As the material to serve as a Li source, lithium fluoride is named.
Examples of the material serving as an alkaline earth metal element source (hereinafter referred to as the alkaline earth metal material) are magnesium fluoride, calcium fluoride, strontium fluoride and barium fluoride, any of which is selected according to the crystal of the intended composition. Further examples usable as the alkaline earth metal material are composite compounds such as calcium magnesium fluoride, calcium strontium fluoride, calcium barium fluoride, magnesium strontium fluoride, magnesium barium fluoride, strontium barium fluoride, calcium magnesium strontium fluoride, calcium magnesium barium fluoride, calcium strontium barium fluoride, calcium strontium barium fluoride, and calcium magnesium strontium barium fluoride.
Examples of the material serving as a metal element source (hereinafter referred to as the metal element material) are aluminum fluoride, gallium fluoride and scandium fluoride, any of which is selected according to the crystal of the intended composition. Further examples usable as the metal element material are composite compounds such as aluminum gallium fluoride, aluminum scandium fluoride, gallium scandium fluoride, and aluminum gallium scandium fluoride.

These three types of materials are formed into a material mixture of a stoichiometric compositionconformedto the chemical composition of the desired crystal. By melting the material mixture and subjecting the melt to crystal growth, the desired metal fluoride crystal can be produced. However, the metal element materials such as lithium fluoride and aluminum fluoride are apt to volatilize compared with the alkaline earth metal material such as calcium fluoride. Thus, there maybe a deviation in the melt composition during melt-heating of the materials, and the resulting crystal may be cloudy. In this case, it is effective to use an excess of lithium fluoride and the transition metal material over the alkaline earth metal material. However, they are preferably used in excess of 10 mol% or less based on the alkaline earthmetal material in order to avoidprecipitation of a heterogeneous phase other than the intended crystal.

As a material for a Eu source, europium fluoride is used.
Examples of the material serving as an alkali metal element source (hereinafter referred to as the alkali metal material) are sodium fluoride, potassium fluoride, rubidium fluoride and cesium fluoride. They may be used alone or in combination.

Then, the crucible 5 charged with the above materials, an after-heater 1, a heater 2, a heat insulator 3, and a stage 4 are set as shown in Fig. 1. The interior of a chamber 6 is evacuated to 1.0x10⁻³ Pa or lower using a vacuum evacuator, and then an inert gas such as high purity argon is introduced into the chamber 6 for gas exchange. The pressure inside the chamber after the gas exchange is not limited, but is generally atmospheric pressure. The gas exchange operation can remove water adhering to the materials or the interior of the chamber, and can prevent the deterioration of the crystal due to such water. To avoid the influence of water which cannot be removed even by the gas exchange operation, it is preferred to use a solid scavenger such as zinc fluoride or a gaseous scavenger such as tetrafluoromethane. If the solid scavenger is used, a method of mixing it into the materials beforehand is preferred. If the gaseous scavenger is used, a method of mixing it with the above inert gas and introducing the mixture into the chamber is preferred.

After the gas exchange operation is performed, the materials are heated by a high frequency coil 7 until they are melted. Then, a melt of the molten materials is pulled out through the hole of the crucible bottom to start the growth of a crystal. When a metal fluoride crystal is produced by the micro-pulling-down method, the wetting properties of the material melt relative to the crucible are so poor that the melt may difficultly discharge through the hole at the bottom of the crucible. In this case, a metal wire is provided at the leading end of a pulling-down rod, and the metal wire is inserted into the crucible through the hole in the bottom of the crucible. After the material melt is stuck to the metal wire, the material melt is pulled down together with the metal wire, whereby a crystal can be grown. For example, the high frequency output is adjusted to raise the temperature of the materials gradually from the melting point of the metal fluoride. During this process, the metal wire is inserted into the hole at the bottom of the crucible, and pulled out. This procedure is repeated until the material melt is withdrawn along with the metal wire, to start the growth of the crystal. Any material can be used, without limitation, for the metal wire, as long as it is a material substantially unreactive with the material melt. However, a material with excellent corrosion resistance at high temperatures, such as W-Re alloy, is preferred.
After the withdrawal of the material melt by the metal wire is carried out, the melt is continuously pulled down at a constant pulling-down speed, whereby a crystal can be obtained. The pulling-down speed is not limited, but is preferably in the range of 0.5 to 10 mm/hr.

With production of the metal fluoride crystal of the present invention, an annealing operation may be performed after the production of the crystal, for the purpose of eliminating a crystal defect of the crystal due to thermal strain.
The resulting metal fluoride crystal has satisfactory processability, and is easy to process into a desired shape for use. During processing, a cutter such as a blade saw or a wire saw, a grinder, or an abrasive wheel, which is publicly known, can be used without any limitations.

The metal fluoride crystal can be processed into desired shapes for use as various light-emitting devices. They can be utilized preferably as light-emitting devices for photolithography, cleaning of semiconductor and liquid crystal substrates, sterilization, next-generation large capacity optical disks, and medical care (ophthalmologic treatment, DNA cleavage), and further as neutron scintillators.
When the metal fluoride crystal is used as a neutron scintillator, its shape may be any shape, including the shape of a plate, a block, or an array of a plurality of quadrangular prismatic crystal arranged. The neutron scintillator is combined with a photodetector such as a photomultiplier tube, whereby a neutron detector can be constituted. With this neutron detector, scintillation light emitted from the neutron scintillator upon irradiation with neutrons is converted into an electrical signal by the photomultiplier tube, whereby the presence or absence and strength of neutrons can be grasped as the electrical signal. Scintillation light emitted from the crystal of the present invention is light with a wavelength of about 350 to 400 nm, and the photomultiplier tube capable of detecting light in this region can be used particularly preferably. Specific examples of such a photomultiplier tube are R7600U and H7416 produced by HAMAMATSU PHOTONICS K.K. Any limitations are not imposed on the structure of the neutron detector or its production method, and publicly known structures and methods can be adopted.

Concretely, there can be named, for example, a method which comprises adhering the neutron scintillator of the present invention to a photoelectric surface of the photomultiplier tube with the use of an optical grease or the like, applying a high voltage to the photomultiplier tube, and measuring an electrical signal outputted by the photomultiplier tube. In order to analyze the intensity of neutron by utilizing the electrical signal from the photomultiplier tube, an amplifier, a multichannel pulse height analyzer or the like may be provided at a stage subsequent to the photomultiplier tube.
The neutron scintillator composed of the eutectic according to the present invention can be combined with a position-sensitive photodetector to construct a neutron imaging device. As the position-sensitive photodetector, a position-sensitive photomultiplier tube can be preferably used. Its examples include XP85012 produced by PHOTONIS INC.

### Examples:

Hereinbelow, the present invention will be described specifically by reference to its Examples, but the present invention is in no way limited by these Examples. Moreover, not all of combinations of the features described in the Examples are essential to the means for solution to problems that the present invention adopts.

### Example 1

### [Metal fluoride crystal]

A crystal of lithium calcium aluminum fluoride containing Eu and Na was produced using the manufacturing apparatus shown in Fig. 1. Lithium fluoride (⁶Li isotopic ratio 95%), calcium fluoride, aluminum fluoride, europium fluoride and sodium fluoride, each having purity of 99.99%, were used as materials. The after-heater 1, the heater 2, the heat insulator 3, the stage 4, and the crucible 5 used were made of high purity carbon, and the shape of the hole provided in the bottom of the crucible was a cylindrical shape 2.0 mm in diameter and 0.5 mm in length.

First, 0.54 g of lithium fluoride, 1.62 g of calcium fluoride, 1. 74 g of aluminum fluoride, 87 mg of europium fluoride, and 17 mg of sodium fluoride were weighed, and thoroughly mixed, followed by charging the mixture into the crucible 5. The crucible 5 charged with the materials was mounted above the after-heater 1, and the heater 2 and the heat insulator 3 were sequentially installed around them.
Then, the interior of the chamber 6 was evacuated to 5.0x10⁻⁴ Pa by the vacuum evacuator comprising an oil-sealed rotaryvacuum pump and an oil diffusion pump. Simultaneously, heating was carried out using the high frequency coil 7 so that the temperature inside the crucible during evacuation would reach 570K.
A 95 vol.% argon-5 vol.% tetrafluoromethane gas mixture was introduced into the chamber 6 and, using the high frequency coil 7, the output of the high frequency heating coil was adjusted such that the heating temperature became 790K, with the temperature at the bottom of the crucible being measured. The pressure within the chamber 6 after the mixed gas exchange was set at atmospheric pressure and, in this state, heating was continued for 30 minutes. Then, with the heating by the high frequency heating coil being continued, evacuation was performed, and an argon gas was further introduced into the chamber 6 for gas exchange. The pressure within the chamber 6 after the argon gas exchange was atmospheric pressure. The same procedure was performed twice.

Using the high frequency heating coil 7, the materials were heated to the melting point of lithium calcium aluminum fluoride until they were melted. Then, the high frequency output was adjusted to raise the temperature of the material melt gradually. During this process, a metal wire comprising a W-Re alloy, which was provided at the leading end of a pulling-down rod 8, was inserted into the hole in the bottom of the crucible 5, and pulled down. This procedure was repeated to withdraw the material melt through the hole. The high frequency output was fixed to maintain the temperature at this time, and the melt of the materials was pulled down to start the growth of a crystal. The melt was pulled down continuously for 14 hours at a rate of 1 mm/hr, whereby a crystal of lithium calcium aluminum fluoride containing Eu and Na and measuring 2.1 mm in diameter and 40 mm in length was finally obtained.
ICP analysis was conducted to investigate the contents of various ions in the crystal, showing that the Eu content was 0.082 mol% and the Na content was 0.88 mol% in the crystal.

### [Neutron scintillator]

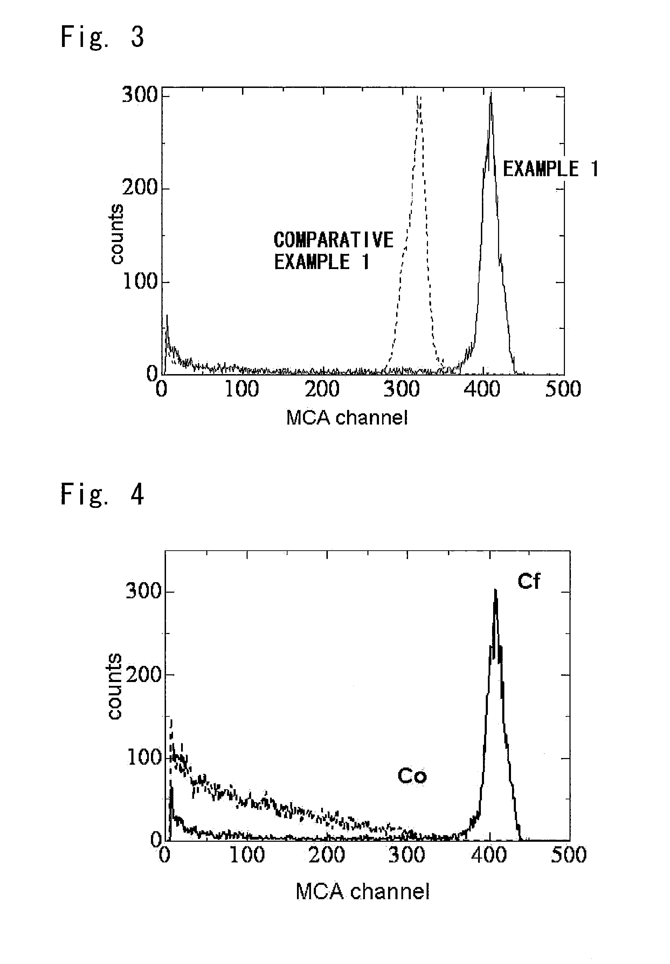

The Eu-Na-containing lithium calcium aluminum fluoride crystal obtained in Example 1 was cut to a length of about 10 mm by a blade saw equipped with a diamond cutoff wheel, and ground at side surfaces thereof to be processed into a shape 10 mm in length, 2 mm in width and 1 mm in thickness. Then, the processed crystal was mounted on a neutron detection scintillator unit of an apparatus shown in Fig. 2. This apparatus was irradiated with neutrons from ²⁵²Cf (polyethylene moderation, 1 to 2 MeV, 3.7 MBq), and the amount of luminescence was measured. The results are shown in Fig. 3. Fig. 3 shows a pulse height spectrum. The abscissa of the pulse height spectrum represents the pulse height value of the electrical signal, namely, the amount of luminescence of scintillation light. Here, it indicates the value of the pulse height channel of a multichannel pulse height analyzer. The ordinate represents the frequency of the electrical signals showing each pulse height value. The frequency was expressed as the number of times (counts) the electrical signals concerned were measured. From Fig. 3, it can be understood that the amount of luminescence increased by incorporating Na. Besides, the amount of luminescence was measured using the same apparatus, with ²⁵²Cf being replaced by ⁶⁰Co to irradiate the apparatus with gamma rays. The results are shown in Fig. 4. From the results, it can be understood that the lithium calcium aluminum fluoride crystal containing Eu and Na has satisfactory N/γ discrimination ability.

### Comparative Example 1

### [Metal fluoride crystal containing no alkali metal]

Crystal growth was performed in the same manner as in Example 1, except that 0.54 g of lithium fluoride, 1.63 g of calcium fluoride, 1.75 g of aluminum fluoride, and 87 mg of europium fluoride were weighed as raw materials. Finally, a lithium calcium aluminum fluoride crystal containing Eu and measuring 2.1 mm in diameter and 40 mm in length was obtained.

### [Neutron scintillator]

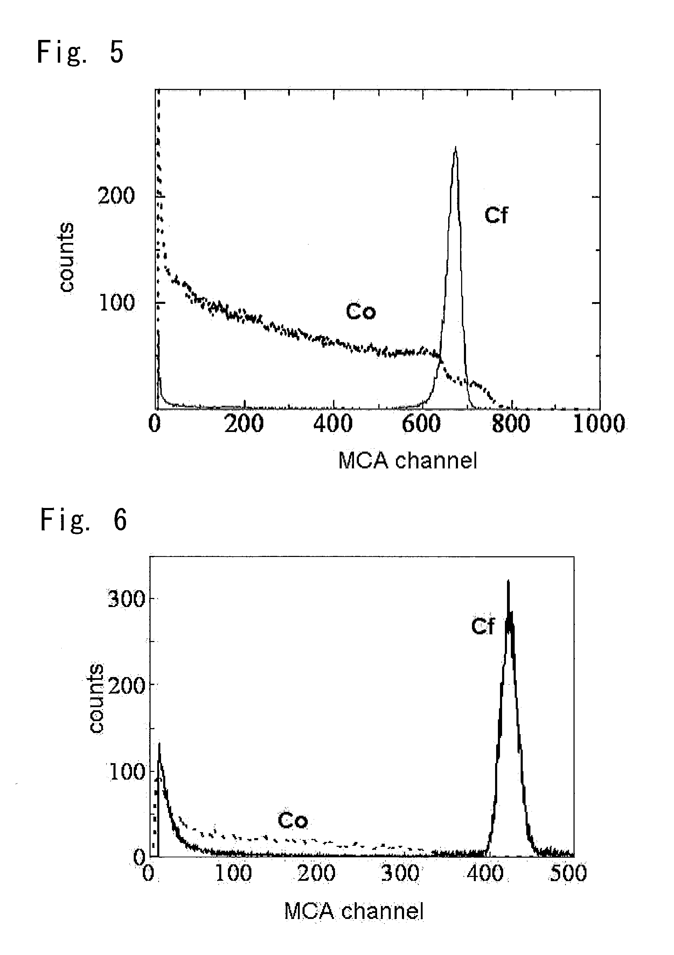

Irradiation with neutron and irradiation with gamma rays were performed, and the amounts of luminescence were measured, in the same manner as in Example 1. The results obtained upon the irradiation with neutron are shown in Figs. 3 and 5, while the results obtained upon the irradiation with gamma rays are shown in Fig. 5. Fig. 5 demonstrates that the Na-free crystal is insufficient in N/γ discrimination ability.

### Example 2

### [Metal fluoride crystal]

Crystal growth was performed in the same manner as in Example 1, except that 0.54 g of lithium fluoride, 1.69 g of calcium fluoride, 1. 82 g of aluminum fluoride, 90 mg of europium fluoride and 9 mg of sodium fluoride were used as raw materials. Finally, a lithium calcium aluminum fluoride crystal containing Eu and measuring 2.1 mm in diameter and 40 mm in length was obtained.
ICP analysis was conducted to investigate the contents of various ions in the crystal, showing that the Eu content was 0.087 mol% and the Na content was 0.44 mol% in the crystal.

### [Neutron scintillator]

Irradiation with neutron and irradiation with gamma rays were performed, and the amounts of luminescence were measured, in the same manner as in Example 1. The results are shown in Fig. 6. FromFig. 6, it can be understood that the lithium calcium aluminum fluoride crystal containing Eu and Na has satisfactory N/γ discrimination ability.

### Example 3

### [Metal fluoride crystal]

Crystal growth was performed in the same manner as in Example 1, except that 1.09 g of lithium fluoride, 3.39 g of calcium fluoride, 3.65 g of aluminum fluoride, 182 mg of europium fluoride and 1.8 mg of sodium fluoride were used as raw materials. Finally, a lithium calcium aluminum fluoride crystal containing Eu and measuring 2.1 mm in diameter and 40 mm in length was obtained.
ICP analysis was conducted to investigate the contents of various ions in the crystal, showing that the Eu content was 0.090 mol% and the Na content was 0.04 mol% in the crystal.

### [Neutron scintillator]

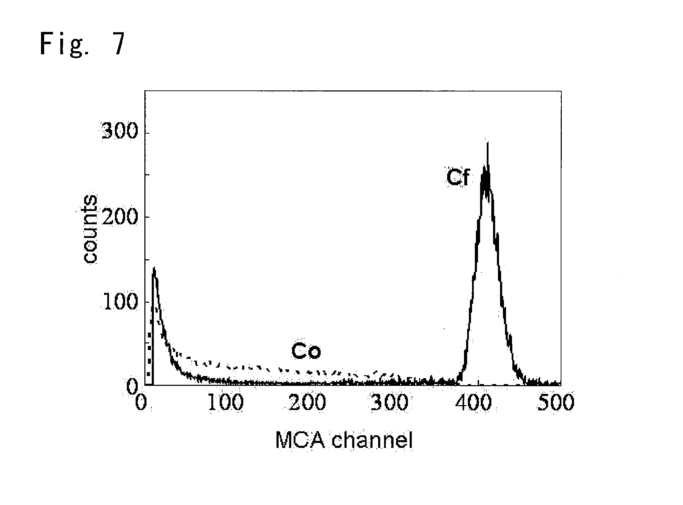

Irradiation with neutron and irradiation with gamma rays were performed, and the amounts of luminescence were measured, in the same manner as in Example 1. The results are shown in Fig. 7. FromFig. 7, it can be understood that the lithium calcium aluminum fluoride crystal containing Eu and Na has satisfactory N/γ discrimination ability.

### Explanations of Letters or Numerals:

- 1: After-heater
- 2: Heater
- 3: Heat insulator
- 4: Stage
- 5: Crucible
- 6: Chamber
- 7: High frequency coil
- 8: Pulling-down rod
- 9: Photomultiplier tube
- 10: Light-shielding material
- 11: Neutron detection scintillator unit

## Claims

1. A metal fluoride crystal represented by the chemical formula LiM¹M²_{F6}
where M¹ represents at least one alkaline earth metal element selected from the group consisting of Mg, Ca, Sr and Ba, and M² represents at least one metal element selected from the group consisting of Al, Ga and Sc,
wherein the crystal contains at least one alkali metal element selected from the group consisting of Na, K, Rb and Cs, and also contains Eu.

2. The metal fluoride crystal according to claim 1, wherein a content of the alkali metal element is 0.001 to 10 mol% based on the metal fluoride crystal, and a content of the Eu is 0.001 to 5 mol% based on the metal fluoride crystal.

3. The metal fluoride crystal according to claim 1, wherein the alkali metal element is Na.

4. The metal fluoride crystal according to claim 1, wherein the metal fluoride crystal is lithium calcium aluminum fluoride (LiCaAlF₆).

5. The metal fluoride crystal according to claim 1, wherein an isotopic ratio of ⁶Li is 50% or higher.

6. A light-emitting device comprising the metal fluoride crystal according to claim 1.

7. The light-emitting device according to claim 6, wherein the light-emitting device is a neutron scintillator.
